# EUROPEAN PATENT APPLICATION

(11) **EP 4 675 004 A1**
(43) Date of publication of application: **07.01.2026**
(21) Application number: 25185714.0
(22) Date of filing: 26.06.2025
(51) Int. Cl.: C23C 14/04, C23C 14/50, H01K 3/00, H01L 21/683, H10K 71/16

(54) **DEPOSITION APPARATUS AND DEPOSITION METHOD USING THE SAME**

(30) Priority: 04.07.2024 KR 20240088312
(71) Applicant: Samsung Display Co., Ltd., Yongin-si, Gyeonggi-do (KR)
(72) Inventor: LEE, Sungyong, Yongin-si (KR); KANG, Eugene, Yongin-si (KR); SEO, Changwook, Yongin-si (KR); SUNG, Byunghun, Yongin-si (KR); OH, Daeyoung, Yongin-si (KR); YUN, Seung Geun, Yongin-si (KR); LEE, Sangkeun, Yongin-si (KR); JEONG, Yongwoo, Yongin-si (KR)
(74) Representative: Marks & Clerk LLP

(57) **Abstract**

A deposition apparatus includes: a support, which is disposed on a bottom surface of a substrate to overlap an edge of the substrate in a plan view; a clamp disposed on the support and the edge of the substrate; and an electrostatic chuck including a flat part and a plurality of protrusions, where the flat part is configured to be disposed on a top surface of the substrate and the plurality of protrusions protrude from an edge of the flat part. A part of the clamp is disposed between protrusions adjacent to each other among the plurality of protrusions, and a groove is defined in a bottom surface of each of the plurality of protrusions and configured to overlap the edge of the substrate in the plan view.

## Description

### BACKGROUND

The present disclosure herein relates to a deposition apparatus and a deposition method using the same.

The display device outputs images or videos through the display area to provide various visual information to the user. Among the display devices, organic light-emitting display devices have the advantages of a wide viewing angle, excellent contrast, and fast response speed. The display area of such an organic light-emitting display device consists of a plurality of pixels, and the plurality of pixels may provide the display area through a process in which a deposition material is deposited.

### SUMMARY

The present disclosure provides a deposition apparatus capable of preventing a substrate from being damaged and a deposition method using the same.

An embodiment of the invention provides a deposition apparatus including: a support, which is disposed on a bottom surface of a substrate to overlap an edge of the substrate in a plan view; a clamp disposed on the support and the edge of the substrate; and an electrostatic chuck including a flat part and a plurality of protrusions, where the flat part is configured to be disposed on a top surface of the substrate and the plurality of protrusions protrude from an edge of the flat part. A part of the clamp is disposed between protrusions adjacent to each other among the plurality of protrusions, and a groove is defined in a bottom surface of each of the plurality of protrusions and configured to overlap the edge of the substrate in the plan view.

In an embodiment of the invention, a deposition apparatus includes: a support, which is disposed on a bottom surface of a substrate to overlap an edge of the substrate in a plan view; a clamp disposed on the support to overlap the edge of the substrate; and an electrostatic chuck including a flat part and a plurality of protrusions, where the flat part is configured to be disposed on a top surface of the substrate and the plurality of protrusions extend from the flat part. A part of the clamp is disposed between protrusions adjacent to each other among the plurality of protrusions, and a bottom surface of each of the plurality of protrusions has a stepped portion.

In an embodiment of the invention, a deposition method includes: placing a substrate between a support and a clamp to fix the substrate; moving an electrostatic chuck, which is disposed on the support and the clamp, downward to be disposed adjacent to a top surface of the substrate; moving the electrostatic chuck downward to be disposed directly on the top surface of the substrate; and moving the support, the clamp, and the electrostatic chuck downward so that the substrate is disposed directly on a top surface of a mask disposed below the support. The electrostatic chuck includes: a flat part having a major surface parallel to a plane defined by a first direction and a second direction intersecting the first direction; and a plurality of protrusions extending from an edge of the flat part in the first direction and overlapping an edge of the substrate in a direction perpendicular to the plane. A groove is defined in a bottom surface of each of the plurality of protrusions, which overlaps the edge of the substrate in the direction perpendicular to the plane.

At least some of the above and other features of the invention are set out in the claims.

### BRIEF DESCRIPTION OF THE FIGURES

The accompanying drawings are included to provide a further understanding of the invention and are incorporated in and constitute a part of this specification. The drawings illustrate embodiments of the invention and, together with the description, serve to explain principles of the invention. In the drawings:
FIG. 1 is a cross-sectional view of a deposition apparatus according to an embodiment of the invention;
FIG. 2 is a perspective view of a mask assembly shown in FIG. 1;
FIG. 3 is a perspective view of the electrostatic chuck shown in FIG. 2;
FIG. 4 is a cross-sectional view corresponding to line I-I' shown in FIG. 3;
FIG. 5A is a plan view illustrating a bottom surface of the electrostatic chuck shown in FIG. 4;
FIG. 5B is an enlarged plan view corresponding to a first area AA1 shown in FIG. 5A;
FIG. 5C is a cross-sectional view corresponding to line II-II' shown in FIG. 3;
FIG. 6A is a plan view of a bottom surface of the electrostatic chuck according to an embodiment of the invention;
FIG. 6B is a plan view of a portion corresponding to a second area AA2 shown in FIG. 6A;
FIGS. 7A through 7E are views for explaining a deposition method using the deposition apparatus shown in FIG. 1;
FIG. 8 is an enlarged view of a portion corresponding to a third area AA3 shown in FIG. 7B;
FIG. 9 is a plan view of a display panel manufactured using the deposition apparatus shown in FIG. 1;
FIG. 10 is a view illustrating an example of a cross-section of one pixel shown in FIG. 9; and
FIG. 11 is a drawing for explaining a deposition process shown in FIG. 7E.

### DETAILED DESCRIPTION

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present.

Like numbers refer to like elements throughout. The thickness and the ratio and the dimension of the element are exaggerated for effective description of the technical contents. As used herein, the term "and/or" includes any and all combinations of one or more of the associated listed items.

It will be understood that, although the terms "first," "second," etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures.

It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

"About" or "substantially the same" as used herein are inclusive of the stated value and mean within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5% or 2% of the stated value. Hereinafter, the invention will be explained in detail with reference to the accompanying drawings.

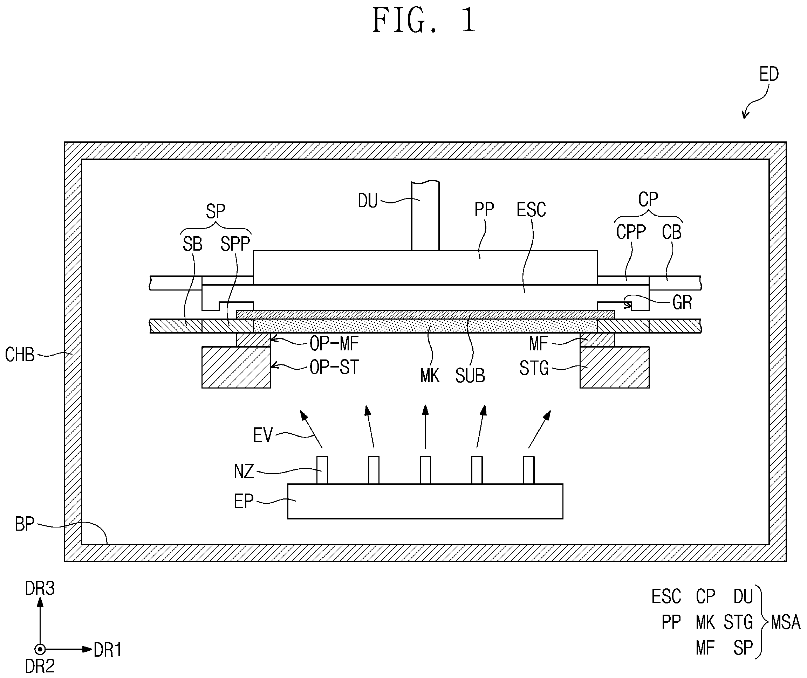

FIG. 1 is a cross-sectional view of a deposition apparatus according to an embodiment of the invention.

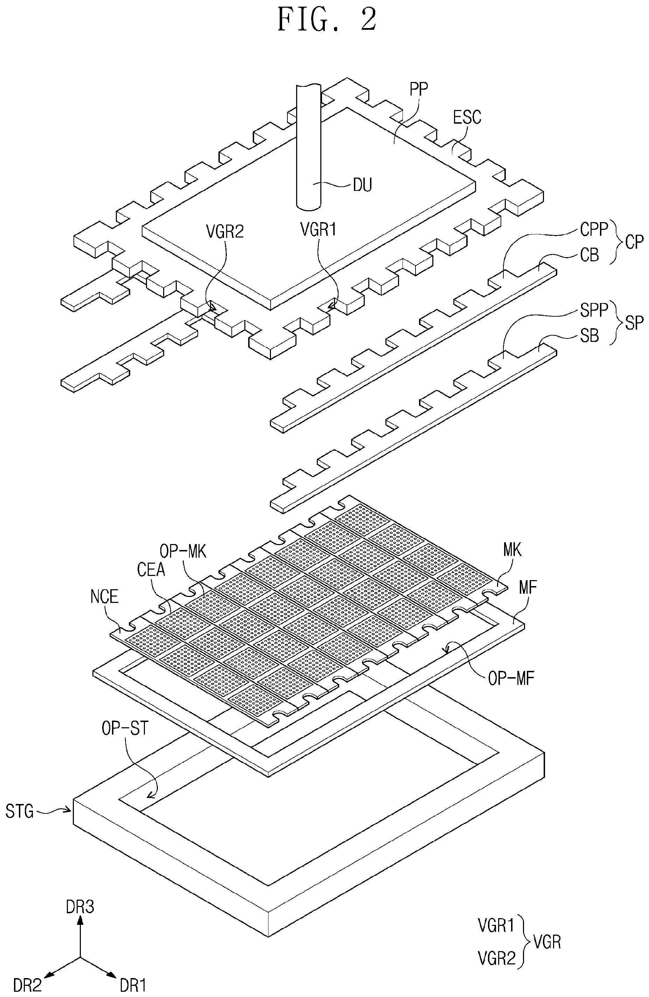

FIG. 2 is a perspective view of a mask assembly shown in FIG. 1.

For example, a substrate SUB is omitted in FIG. 2.

Referring to FIG. 1, a deposition apparatus ED according to an embodiment of the invention may include a mask assembly MSA, a chamber CHB, a plurality of nozzles NZ, and a deposition source EP. The chamber CHB may be provided with an internal space and an enclosed space and may set the deposition conditions to a vacuum. The chamber CHB may include at least one gate, and the chamber CHB may be opened and closed through the gate. The mask assembly MSA and a substrate SUB may enter and exit through the gate provided on the chamber CHB.

The chamber CHB may include a bottom surface BP, a ceiling surface, and sidewalls. The bottom surface BP of the chamber CHB may be parallel to a plane defined by a first direction DR1 and a second direction DR2. A normal line to the bottom surface of the chamber CHB may be parallel to a third direction DR3.

Referring to FIGS. 1 and 2, the mask assembly MSA may include a fixing member PP, an electrostatic chuck ESC, a plurality of clamps CP, a plurality of supports SP, a plurality of masks MK, a mask frame MF, a stage STG, and a driving part DU. The fixing member PP may be disposed inside the chamber CHB and may face a deposition source EP in the third direction DR3. The fixing member PP may allow the substrate SUB to closely contact the mask MK. The fixing member PP may include magnetic bodies to allow the mask MK to closely contact the substrate SUB. For example, the magnetic bodies may generate magnetic force to fix the mask MK, and the substrate SUB disposed between the mask MK and the fixing member PP may closely contact the mask MK. However, an embodiment of the invention is not limited thereto, and the fixing member PP may include a jig or a robot arm which holds the mask MK.

The driving part DU may be coupled to a top surface of the fixing member PP. The driving part DU may have a cylindrical shape extending in the third direction DR3, however an embodiment of the invention is not limited thereto and the driving part DU may have various shapes. The driving part DU may reciprocate in the third direction DR3 to allow the fixing member PP to reciprocate in the third direction DR3.

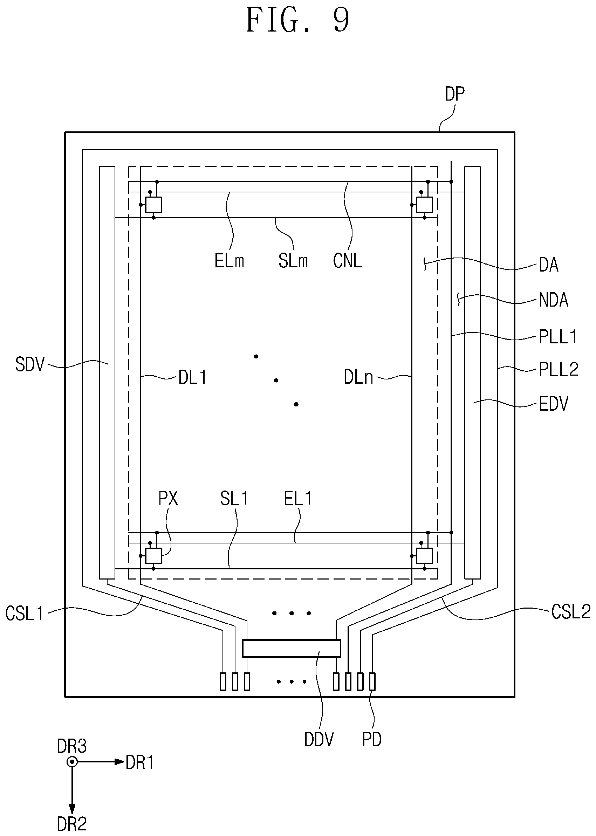

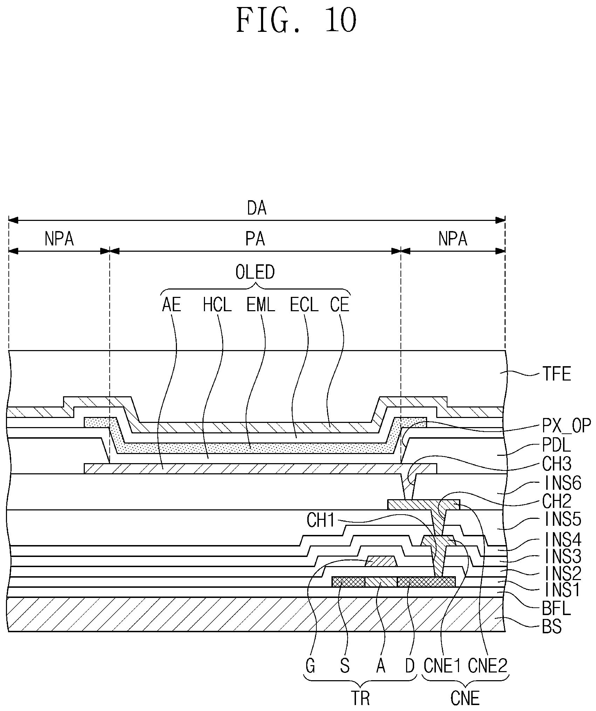

The substrate SUB may be disposed between the mask MK and the fixing member PP. The substrate SUB may be an object to be processed onto which a deposition material is deposited. The substrate SUB may include a support substrate, and a synthetic resin material disposed on the support substrate. In the later parts of the process of manufacturing a display panel DP (see FIG. 9), the support substrate may be removed, and the synthetic resin layer may correspond to a base substrate BS in FIG. 10.

The electrostatic chuck ESC may be disposed between the substrate SUB and the fixing member PP. The electrostatic chuck ESC may generate electrostatic force by using electrostatic induction. The electrostatic chuck ESC may chuck or de-chuck the substrate SUB through electrostatic force.

As shown in FIG. 2, the electrostatic chuck ESC may have a shape corresponding to a shape of a portion of a rectangle. The electrostatic chuck ESC may include short sides extending in the first direction DR1 and long sides extending in the second direction DR2.

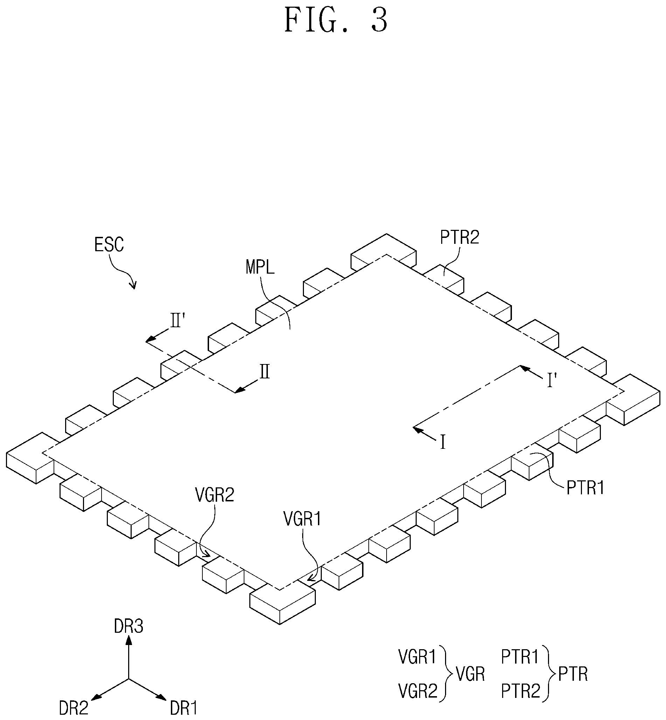

Accommodation grooves VGR may be defined in an edge of the electrostatic chuck ESC. The accommodation grooves VGR may include first accommodation grooves VGR1 and second accommodation grooves VGR2. The first accommodation grooves VGR1 may be arranged along the long sides of the electrostatic chuck ESC. The second accommodation grooves VGR2 may be arranged along the short sides of the electrostatic chuck ESC. The accommodation grooves VGR of the electrostatic chuck ESC will be described in detail in FIG. 3.

As shown in FIG. 1, grooves GR may be defined in a bottom surface of the electrostatic chuck ESC overlapping the substrate SUB in a plan view. The grooves GR defined in the bottom surface of the electrostatic chuck ESC will be described in detail below.

Although not shown, the electrostatic chuck ESC may reciprocate in the third direction DR3 by an external motor. Accordingly, the electrostatic chuck ESC may move closer to or away from the substrate SUB.

The supports SP may be adjacent to each other and disposed on both sides of the substrate SUB, which oppose each other in the first direction DR1. The supports SP may be disposed on a bottom surface of the substrate SUB which faces the deposition source EP. The supports SP may overlap an edge of the substrate SUB in a plan view. The supports SP may support the bottom surface of the substrate SUB.

The supports SP may include first bars SB and support plates SPP. The first bars SB may extend in the second direction DR2.

The support plates SPP may be arranged in the second direction DR2. The support plates SPP may be arranged to correspond to the arrangement of the first accommodation grooves VGR1. The support plates SPP may be disposed at one side, which is adjacent to the electrostatic chuck ESC, of each of the first bars SB, which oppose each other in the first direction DR1. Each of the support plates SPP may extend from the one side of each of the first bars SB toward the substrate SUB in the first direction DR1. Specifically, the first bars SB and the support plates SPP may be integrally provided. As shown in FIG. 1, the support plates SPP may overlap the edge of the substrate SUB in a plan view. The substrate SUB may be disposed on the support plates SPP.

For example, although the supports SP are disposed on opposite sides of the substrate SUB in the first direction DR1, it is not limited thereto. The supports SP may be additionally disposed on opposite sides, in the second direction DR2, of the substrate SUB in another embodiment.

The clamps CP may be disposed on the supports SP. The clamps CP may be disposed on the substrate SUB. The substrate SUB may be disposed between the supports SP and the clamps CP. The clamps CP may fix the substrate SUB together with the supports SP.

The clamps CP may include second bars CB and fixing parts CPP. The second bars CB may extend in the second direction DR2. The second bars CB may face the first bars SB in the third direction DR3.

The fixing parts CPP may be disposed at one side, which is adjacent to the electrostatic chuck ESC, of both sides, which oppose each other in the first direction DR1, of each of the second bars CB. The fixing parts CPP may extend from the second bars CB in the first direction DR1. Each of the fixing parts CPP may have a shape corresponding to a shape of each of the first accommodation grooves VGR1. Substantially, the fixing parts CPP and the second bars CB may be integral.

The fixing parts CPP may be arranged in the second direction DR2. The fixing parts CPP may be arranged in a shape corresponding to the support plates SPP. The fixing parts CPP may be arranged in a shape corresponding to the first accommodation grooves VGR1. The fixing parts CPP may overlap the support plates SPP and the edge of the substrate SUB in a plan view.

The fixing parts CPP may be arranged to correspond to the first accommodation grooves VGR1. As shown in FIG. 2, when the electrostatic chuck is adjacent to the substrate SUB, each of the fixing parts CPP may be disposed within a first groove VGR1 corresponding thereto of the first accommodation grooves VGR1.

For example, the clamps CP are disposed on opposite sides of the substrate SUB in the first direction DR1, but it is not limited thereto. The clamps CP may be additionally disposed on opposite sides, in the second direction DR2, of the substrate SUB, and each of which has a shape corresponding to a shape of each of the second accommodation grooves VGR2 in another embodiment.

Although not shown, the supports SP and the clamps CP may be connected to an external driving motor. For example, the driving motor may be connected to the first bars SB and the second bars CB to allow the supports SP and the clamps CP to reciprocate in the third direction DR3.

The mask frame MF may be disposed below the substrate SUB. The mask frame MK may have a rectangular frame shape having short sides extending in the first direction DR1 and long sides extending in the second direction DR2. A frame opening OP-MF may be defined in the mask frame MF having a rectangular frame shape. The frame opening OP-MF may have a rectangular shape.

The mask frame MF may have a predetermined rigidity. For example, the mask frame MF may include metallic materials such as stainless steel (SUS), Invar, nickel (Ni), cobalt (Co), or the like.

The masks MK may be disposed between the mask frame MF and the substrate SUB. The masks MK may extend in the first direction DR1 and be arranged in the second direction DR2. Each of the masks MK may have a rectangular shape having long sides extending in the first direction DR1 and short sides in the second direction DR2.

Each of the masks MK may have opposite sides connected to the mask frame MF. The masks MK may be stretched to cover the frame opening OP-MF. For example, the masks MK may be stretched in the first direction DR1 by a force acting in both the first direction DR1 and in the opposite direction. The stretched masks MK may be connected to the mask frame MF by laser welding.

The masks MK may contain metal. For example, the masks MK may be defined as a fine metal mask.

The masks MK may have a top surface on which a plurality of cell areas CEA and peripheral areas NCE may be defined. For example, each of the cell areas CEA may have a rectangular shape having a long side in the first direction DR1 and a short side in the second direction DR2. However, the shape of each of the cell areas CEA is not limited thereto. The peripheral areas NCE may be a remaining portion of the masks MK excluding the cell areas. The peripheral areas NCE may surround the cell areas CEA.

The cell areas CEA may be arranged in the first direction DR1. For example, each of the masks MK have a top surface on which four cell areas CEA are arranged in the first direction DR1, but the number of the cell areas CEA is not limited thereto.

The cell areas CEA may be arranged to overlap the frame opening OP-MF. The cell areas CEA may not overlap the mask frame MF in a plan view.

The plurality of mask openings OP-MK may be defined in the cell areas CEA. The mask openings OP-MK may be arranged in the first direction DR1 and the second direction DR2. In a plan view, the mask openings OP-MK may overlap the frame opening OP-MF. The frame opening OP-MF and the mask openings OP-MK may be defined in a series in the third direction DR3.

The stage STG may be disposed between the deposition source EP and the mask frame MF. The stage STG may have a rectangular shape having short sides extending in the first direction DR1 and long sides extending in the second direction DR2. A stage opening OP-ST may be defined in the stage STG having a rectangular frame shape. The stage opening OP-ST may have a rectangular shape.

The stage opening OP-ST may overlap the frame opening OP-MF and the mask openings OP-MK in the third direction DR3. The stage opening OP-ST, the frame opening OP-MF and the mask openings OP-MK may be serially defined in the third direction DR3. Accordingly, as shown in FIG. 1, a deposition material EV may pass through the stage opening OP-ST, the frame opening OP-MF and the mask openings OP-MK and be deposited on the substrate SUB.

The deposition source EP may be disposed inside the chamber CHB and face the fixing member PP in the third direction DR3. The deposition source EP may include a storage space in which the deposition material EV is accommodated and at least one nozzle NZ. The deposition material EV may include inorganic materials, metals, or organic materials that may undergo sublimation or vaporization. For example, the deposition material EV may include an organic light-emitting material for providing an emission layer EML (see FIG. 10). The sublimated or vaporized deposition material EV may be sprayed toward the substrate SUB through the nozzle NZ. The stage STG, the mask frame MF, and the masks MK may be disposed in a path through which the deposition material EV supplied to the substrate SUB moves. The deposition material EV may pass through the mask openings OP-MK of the mask MK and then be patterned and deposited on the substrate SUB.

FIG. 3 is a perspective view of the electrostatic chuck ESC shown in FIG. 2.

Referring to FIG. 3, the electrostatic chuck ESC may include a flat part MPL and a plurality of protrusions PTR. The flat part MPL may have a major surface parallel to a plane defined by the first direction DR1 and the second direction DR2. For example, the flat part MPL may extend longer in the second direction DR2 than in the first direction DR1. The normal direction of the plane may be parallel to the thickness direction (third direction) of the electrostatic chuck ESC.

The protrusions PTR may extend from an edge of the flat part MPL. Substantially, the protrusions PTR may be integral with the flat part MPL.

The protrusions PTR may include a plurality of first protrusions PTR1 and a plurality of second protrusions PTR2. The first protrusions PTR1 may extend from the flat part MPL in the first direction DR1. The first protrusions PTR1 may be arranged in the second direction DR2 along long sides of the flat part MPL. The first accommodation grooves VGR1 may be defined by the flat part MPL and the first protrusions PTR1, which are adjacent to each other, in the second direction DR2.

The second protrusions PTR2 may extend from the flat part MPL in the second direction DR2. The second protrusions PTR2 may be arranged in the first direction DR1 along short sides of the flat part MPL. The second accommodation grooves VGR2 may be defined by the flat part MPL and the second protrusions PTR2, which are adjacent to each other, in the first direction DR1.

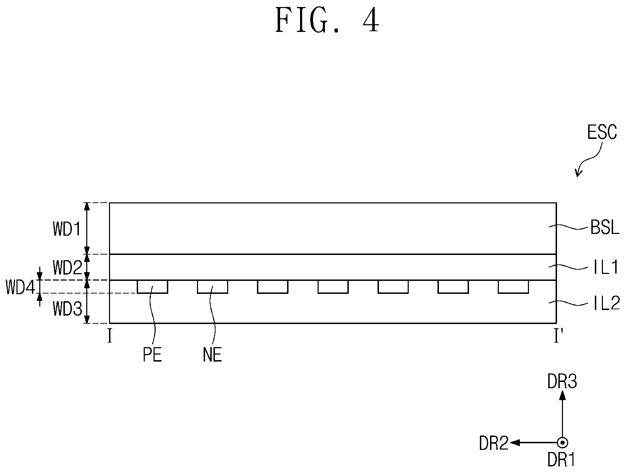

FIG. 4 is a cross-sectional view corresponding to line I-I' shown in FIG. 3.

Referring to FIG. 4, the electrostatic chuck ESC may include a chuck body BSL, a first insulating layer IL1, a second insulating layer IL2, a plurality of anodes PE, and a plurality of cathodes NE.

The chuck body BSL may include ceramic. However, it is only an example, and the material of the chuck body BSL according to an embodiment of the invention is not limited thereto. For example, the chuck body BSL according to an embodiment of the invention may include aluminium (Al), titanium (Ti), stainless steel, alumina (Al₂O₃), yttrium oxide (Y₂O₃), or aluminium nitride.

The first insulating layer IL1 may be disposed below the chuck body BSL. The first insulating layer IL1 may include a material with higher heat resistance and chemical stability than heat resistance and chemical stability of the second insulating layer IL2. For example, the first insulating layer IL1 may include yttrium oxide (Y₂O₃). However, it is only an example, and the material of the first insulating layer IL1 according to an embodiment of the invention is not limited thereto, and the first insulating layer IL1 may include various materials with heat resistance and chemical stability.

The first insulating layer IL1 may have a thickness WD2 less than a thickness WD1 of the chuck body BSL. The first layer IL1 may have the thickness WD2 from about 80 µm (micrometer) to about 100 µm. The chuck body BSL may have the thickness WD1 from about 10 mm (millimeter) to 20 mm.

The second insulating layer IL2 may be disposed below the first insulating layer IL1. The second insulating layer IL2 may include a material with higher thermal conductivity and dielectric properties than thermal conductivity and dielectric properties of the first insulating layer IL1. For example, the second insulating layer IL2 may include alumina (Al₂O₃). However, it is only an example, and the material of the second insulating layer IL2 according to an embodiment of the invention is not limited thereto, and the second insulating layer IL2 may include various materials with thermal conductivity.

The second insulating layer IL2 may have a thickness WD3 greater than the thickness WD2 of the first insulating layer IL1. The second insulating layer IL2 may have the thickness WD3 less than the thickness WD1 of the chuck body BSL. The second insulating layer IL2 may have the thickness WD3 from about 110 µm to about 150 µm.

The plurality of anodes PE and the plurality of cathodes NE may be disposed between the first insulating layer IL1 and the second insulating layer IL2. The second insulating layer IL2 may cover the plurality of anodes PE and cathodes NE. The plurality of anodes PE and the plurality of cathodes NE may have polarities different from each other. The plurality of anodes PE and cathodes NE may be alternately arranged.

The plurality of anodes PE and cathodes NE may each include tungsten (W). However, it is only an example, and a material of each of the plurality of anodes PE and cathodes NE according to an embodiment of the invention may not be limited thereto. For example, the plurality of anodes PE and cathodes NE may each include silver (Ag) or copper (Cu).

Each of the plurality of anodes PE and the plurality of cathodes NE may have the same thickness WD4 as each other. Each of the plurality of anodes PE and cathodes NE may have the thickness WD4 less than a thickness of each of the first and second insulating layer IL1 and IL2. Each of the plurality of anodes PE and cathodes NE may have the thickness WD4 from about 25 µm to about 35 µm.

A positive DC voltage may be applied to the plurality of anodes PE. A first electrostatic force may be generated between the plurality of anodes PE and the substrate SUB. A negative DC voltage may be applied to the plurality of cathodes NE. A second electrostatic force may be generated between the plurality of cathodes NE and the substrate SUB. The first electrostatic force and the second electrostatic force may be electrostatic forces.

The electrostatic chuck ESC may be a bipolar electrostatic chuck. However, it is only an example, a type of the electrostatic chuck ESC according to an embodiment of the invention is not limited thereto. For example, the electrostatic chuck may be a monopolar electrostatic chuck. In this case, a plurality of anodes PE and a plurality of cathodes NE of the electrostatic chuck ESC may be applied with a DC voltage of the same polarity. In a monopolar electrostatic chuck, the plurality of anodes PE and the plurality of cathodes NE may be referred to as electrodes.

When the positive DC voltage is applied to each of the plurality of anodes PE, a portion of the substrate SUB (see FIG. 1) that overlaps with each of the plurality of anodes PE in a plan view may become charged with a negative potential. An electrostatic force due to charges may be generated between the plurality of anodes PE and the corresponding portion of the substrate SUB (see FIG. 1).

When the negative DC voltage is applied to each of the plurality of cathodes NE, the other portion of the substrate SUB (see FIG. 1) that overlaps with each of the plurality of cathodes NE in a plan view may become charged with a positive potential. An electrostatic force due to charges may be generated between the plurality of cathodes NE and the corresponding other portion of the substrate SUB (see FIG. 1).

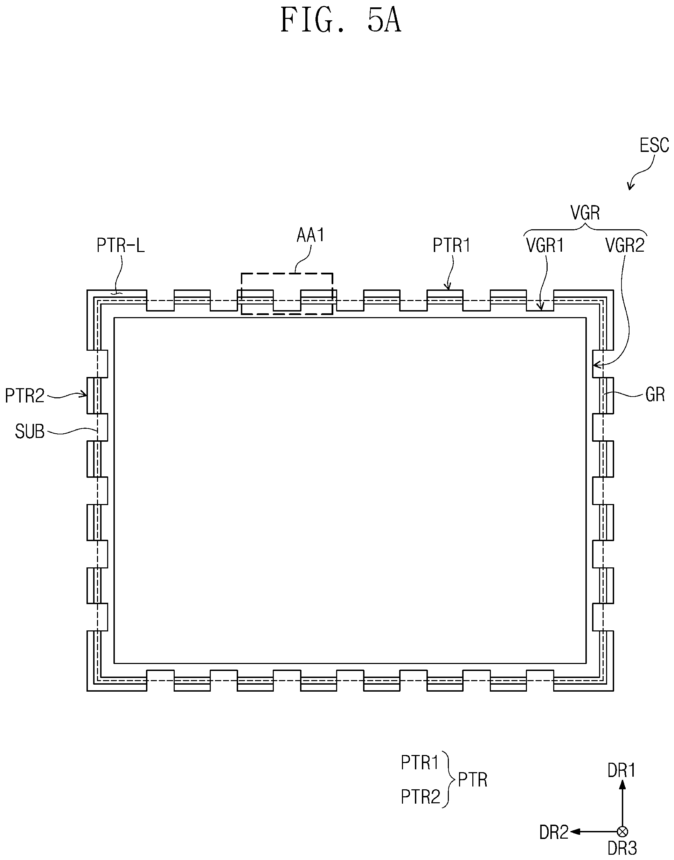

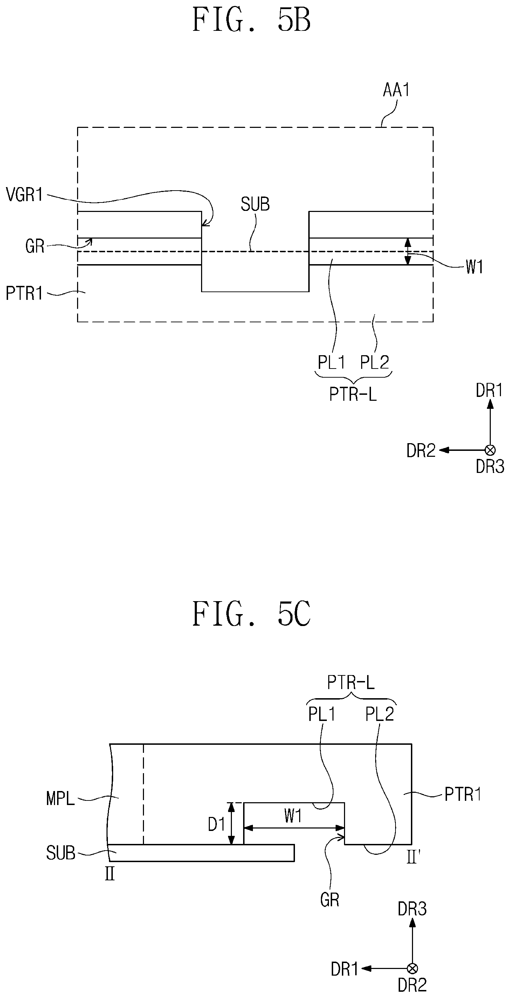

FIG. 5A is a plan view illustrating a bottom surface of the electrostatic chuck shown in FIG. 4. FIG. 5B is an enlarged plan view corresponding to a first area AA1 shown in FIG. 5A. FIG. 5C is a cross-sectional view corresponding to line II-II' shown in FIG. 3. As used herein, the "plan view" is a view in a thickness direction (third direction DR3) of the electrostatic chuck ESC.

For example, in FIGS. 5A and 5B, the substrate SUB is illustrated with a dashed line.

For example, grooves GR defined in a bottom surface of the first protrusions PTR1 are described in FIGS. 5B and 5C, however, the grooves GR defined in the second protrusions PTR2 may be substantially the same.

Among the elements shown in FIGS. 5A to 5C, the description of elements that are the same as those described with reference to the previous figures will be omitted or briefly described.

Referring to FIGS. 5A and 5B, the substrate SUB may be disposed on the bottom surface of the electrostatic chuck ESC. The substrate SUB may be disposed on the flat part MPL. The substrate SUB may be disposed on a portion of a bottom surface PTR-L of the protrusions PTR.

A plurality of grooves GR may be defined in the bottom surface of the electrostatic chuck ESC. The grooves GR may be defined in the bottom surface PTR-L of the protrusions PTR. The grooves GR may overlap the edge of the substrate SUB in a plan view.

The grooves GR defined in the first protrusions PTR1 may extend in the second direction DR2. The grooves GR may extend from one side to the other side of the first protrusions PTR1, which oppose each other in the second direction DR2.

The grooves GR defined in the second protrusions PTR2 may extend in the first direction DR1. The grooves GR may extend from one side to the other side of the second protrusions PTR2, which oppose each other in the first direction.

Referring to FIG. 5B, the bottom surface PTR-L of the first protrusion PTR1 may include a first surface PL1 and a second surface PL2. The first surface PL1 may be defined as a bottom surface of the groove GR. The second surface PL2 may be defined as a bottom surface PTR-L of the first protrusion PTR1, excluding the first surface PL1 of bottom surface PTR-L of the first protrusion PTR.

The first protrusion PTR1 may have a variable thickness. The bottom surface PTR-L of the first protrusion PTR1 may have a step difference. The first surface PL1 and the second surface PL2 may be arranged with a step difference. The first surface PL1 may have a height greater than a height of the second surface PL2. Accordingly, when the substrate SUB is disposed on the bottom surface of the second surface PL2, the edge of the substrate SUB may not contact the first surface PL1.

Referring to FIGS. 5B and 5C, the grooves GR may have a first width W1 of between about 3 mm and about 7 mm in the first direction DR1. When viewed from the second direction DR2, the grooves GR may have a first depth D1 of between about 0.5 mm and about 5 mm in the third direction DR3.

As shown in FIG. 1, a lifting phenomenon may occur on the substrate SUB during the deposition process. The edge of the substrate SUB may move upward with respect to a portion of the substrate SUB that overlaps the flat part MPL in a plan view. When the grooves GR are not defined in the bottom surface of each of the first and second protrusions PTR1 and PTR2, the edge of the substrate SUB may contact the bottom surface of the electrostatic chuck ESC, thereby leading to damage.

However, in one embodiment of the invention, the grooves GR may be defined in the first and second protrusions PTR1 and PTR2 and overlap the edge of the substrate SUB in a plan view. Accordingly, when a lifting phenomenon occurs at the edge of the substrate SUB, the edge of the substrate SUB may be disposed within the grooves GR. Thus, the edge of the substrate SUB may not contact the electrostatic chuck ESC, thereby preventing damage to the substrate SUB.

Although not shown, a plurality of electrodes are disposed on the bottom surface of the electrostatic chuck ESC. An attractive force may be generated by an electrostatic force between the electrodes and the substrate SUB. As a result, the substrate SUB may be fixed to the bottom surface of the electrostatic chuck ESC.

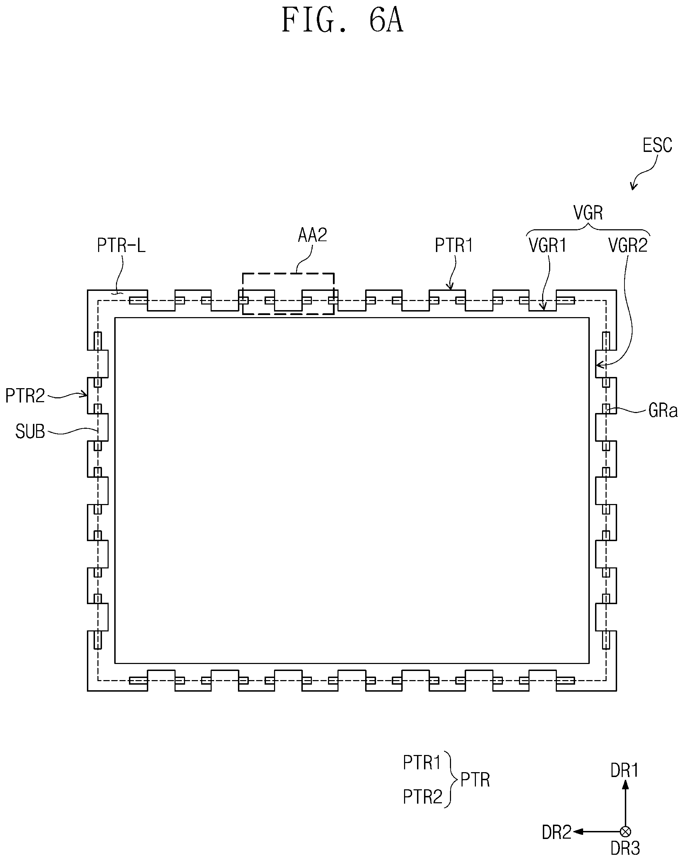

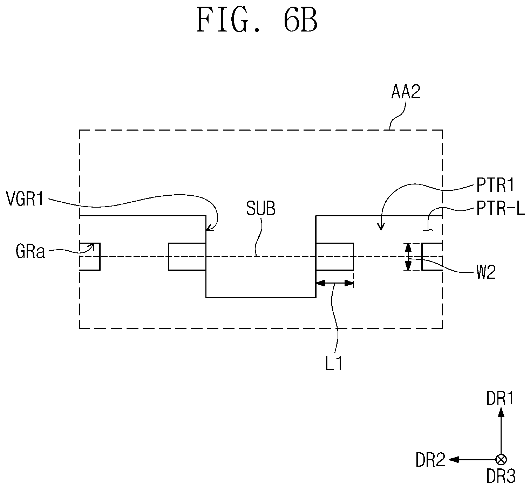

FIG. 6A is a plan view of the bottom surface of the electrostatic chuck ESC according to one embodiment of the invention. FIG. 6B is a plan view of a portion corresponding to the second area AA2 shown in FIG. 6A.

For example, the substrate SUB in FIGS. 6A and 6B is indicated by a dotted line.

Among the elements shown in FIGS. 6A and 6B, descriptions of the elements that are identical to those described with reference to the above-described figures will be omitted or briefly mentioned.

Referring to FIGS. 6A and 6B, a plurality of grooves GRa may be defined in a bottom surface PTR-L of each of the first protrusions PTR1. A plurality of grooves GRa may be defined in a bottom surface of each of the second protrusions PTR2.

As shown in FIG. 6B, the grooves GRa defined in the bottom surface of each of the first protrusions PTR1 may be defined adjacent to opposite sides of the first protrusions PTR1 in the second direction DR2. In a plan view, the grooves GRa may have a second width W2 of between about 3 mm and about 7 mm in the first direction DR1. In a plan view, the grooves GRa may have a first length L1 of between about 3 mm and about 30 mm in the second direction DR2.

Although the grooves GRa defined in the bottom surface of the first protrusions PTR1 were described with reference to FIG. 6B, the grooves GRa defined in the bottom surface of the second protrusions PTR2 may be substantially identical to the grooves GRa defined in the bottom surface of the first protrusions PTR1.

When the grooves GRa extend from one side to the other side of the first protrusions PTR1, which oppose each other in the second direction DR2, the thickness of the portions of the first protrusions PTR1 where the grooves GRa are defined may decrease. Consequently, the rigidity of the first protrusions PTR1 may be reduced.

However, as shown in FIG. 6A, the grooves GRa may be defined in the portions of the first and second protrusions PTR1, PTR2 adjacent to the first and second accommodation grooves VGR1, VGR2. Accordingly, the reduction in the rigidity of the first and second protrusions PTR1, PTR2 may be prevented.

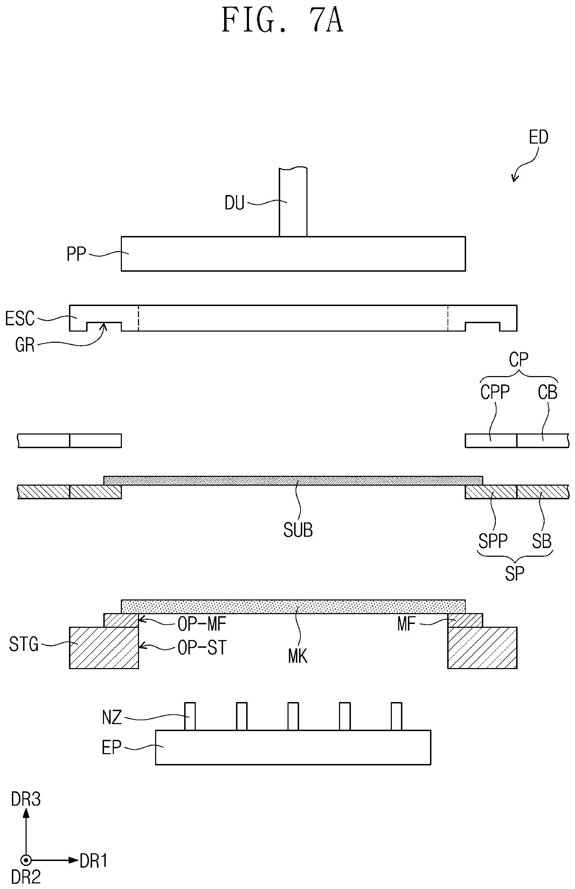

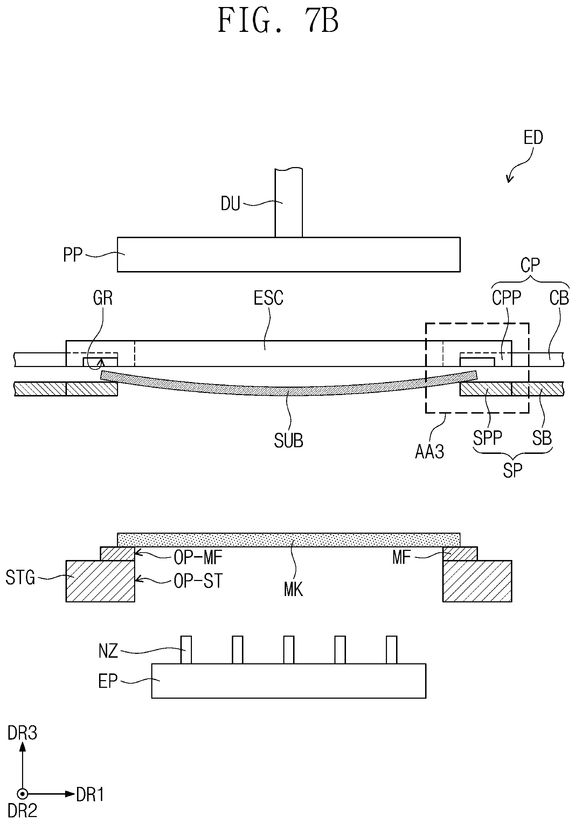

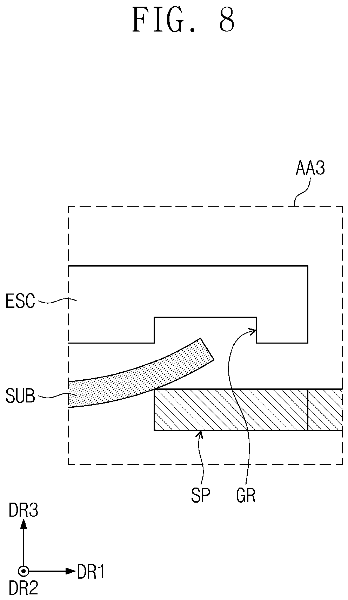

FIGS. 7A to 7E are views for explaining a deposition method using the deposition apparatus shown in FIG. 1. FIG. 8 is an enlarged view of a portion corresponding to a third area AA3 shown in FIG. 7B.

For example, FIGS. 7A to 8 illustrate the deposition apparatus ED when viewed from the second direction DR2.

For the convenience of explanation, the chamber CHB of FIG. 1 is omitted.

For the convenience of explanation, the clamp CP is omitted in FIG. 8.

Among the elements shown in FIGS. 7A to 8, descriptions of the elements that are identical to those described with reference to the above-described figures will be omitted or briefly mentioned.

Referring to FIG. 7A, the deposition method may include a step of placing the substrate SUB between the supports SP and the clamps CP. The substrate SUB may be disposed on the supports SP. The clamps CP may be disposed on the substrate SUB and the supports SP. The substrate SUB may be fixed by the supports SP and the clamps CP.

Referring to FIGS. 7B and 8, after the substrate SUB is disposed between the supports SP and the clamps CP, the electrostatic chuck ESC may move downward toward the substrate SUB. The electrostatic chuck ESC may be adjacent to the top surface of the substrate SUB.

A center of the substrate SUB may sag downward due to gravity. The center of the substrate SUB, which overlaps the frame opening OP-MF in a plan view, may sag downward due to gravity. Therefore, as shown in FIG. 8, the edge of the substrate SUB may move upward.

When the grooves GR are not defined in the portion of the electrostatic chuck ESC, which overlaps the edge of the substrate SUB in a plan view, the edge of the substrate SUB may collide with the bottom surface of the electrostatic chuck ESC. Accordingly, the edge of the substrate SUB may sustain damage.

However, as shown in FIGS. 7B and 8, since the grooves GR are defined in the bottom surface of the electrostatic chuck ESC, the edge of the substrate SUB may not contact the bottom surface of the electrostatic chuck ESC even when the edge of the substrate SUB move upward. The edge of the substrate SUB may be disposed within the grooves GR. Thus, damage to the edge of the substrate SUB may be prevented.

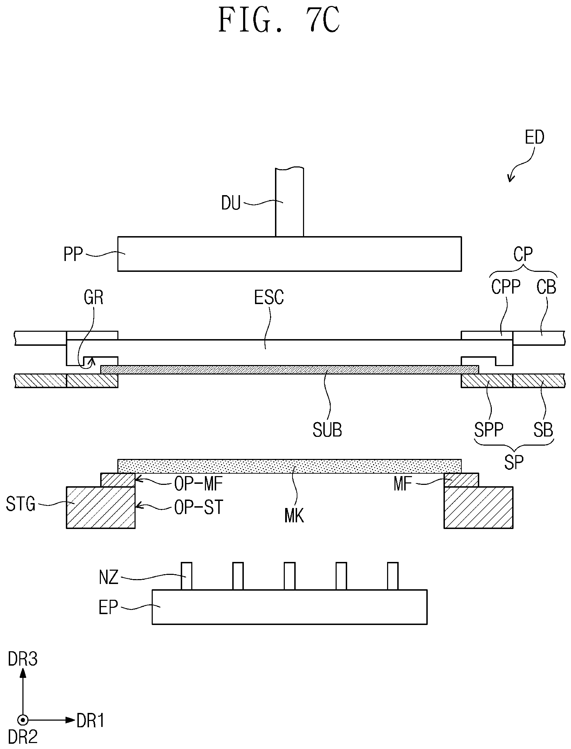

Referring to FIG. 7C, the electrostatic chuck ESC may move downward and be disposed on the top surface of the substrate SUB. The attractive force may be generated due to an electrostatic force between the electrostatic chuck ESC and the substrate SUB. The substrate SUB may be fixed to the bottom surface of the electrostatic chuck ESC due to the attractive force.

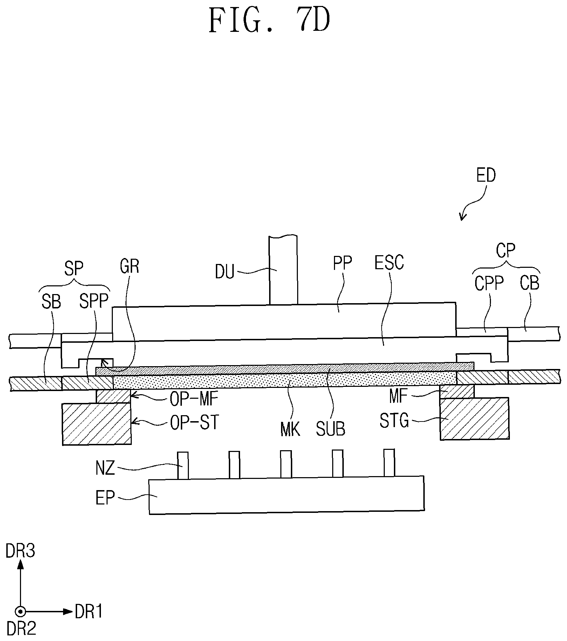

Referring to FIG. 7D, the fixing member PP may move downward and be disposed on the top surface of the electrostatic chuck ESC. Due to the magnetic bodies of the fixing member PP, the attractive force may be generated between the fixing member PP and the masks MK. Accordingly, the masks MK may be closely attached to the substrate SUB.

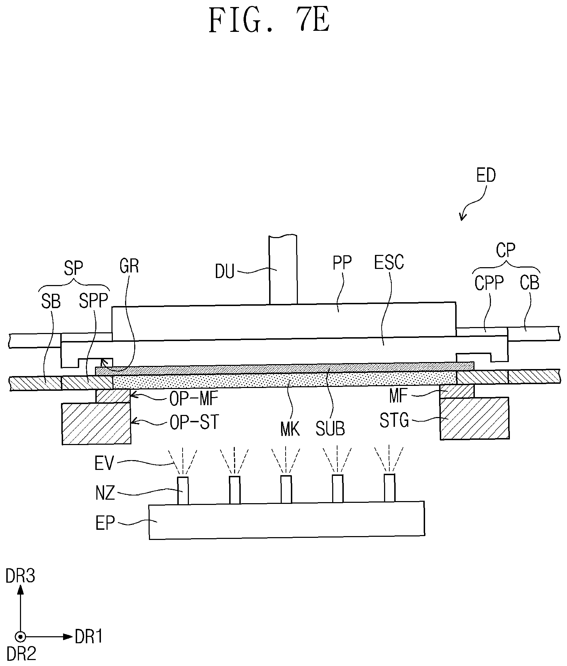

Referring to FIG. 7E, after the masks MK are closely attached to the substrate SUB, the nozzle NZ may spray the deposition material EV toward the substrate SUB. The deposition material EV may pass through the mask openings OP-MK (see FIG. 2) of the mask MK and deposited in a patterned manner on the substrate SUB.

FIG. 9 is a display panel manufactured using the deposition apparatus shown in FIG. 1.

The display panel DP may have a rectangular shape with short sides extending in the first direction DR1 and long sides extending in the second direction DR2, however, the shape of the display panel DP is not limited thereto. The display panel DP may include a display part DA and a non-display part NDA surrounding the display part DA.

The display panel DP may be an emissive display panel. The display panel DP may be an organic light-emitting display panel or a quantum dot light-emitting display panel. An emission layer of the organic light-emitting display panel may include organic light-emitting materials. An emission layer of the quantum dot light-emitting display panel may include quantum dots and quantum rods, and so on. Hereinafter, the display panel DP will be described as an organic light-emitting display panel.

The display panel DP may include a plurality of pixels PX, a plurality of scan lines SL1 to SLm, a plurality of data lines DL1 to DLn, a plurality of light-emitting lines EL1 to ELm, first and second lines CSL1 and CSL2, first and second power lines PLL1 and PLL2, connection lines CNL, and a plurality of pads PD. Here, the reference symbols m and n refer to natural numbers.

The pixels PX may be disposed on the display part DA. A scan driver SDV and an emission driver EDV may be disposed on the non-display part NDA, adjacent to the long sides of the display panel DP, respectively. A data driver DDV may be disposed on the non-display part NDA, adjacent to one of the short sides of the display panel DP. In a plan view, the data driver DDV may be adjacent to a lower end of the display panel DP.

The scan lines SL1 to SLm may extend in the first direction DR1 and be connected to the pixels PX and the scan driver SDV. The data lines DL1 to DLn may extend in the second direction DR2 and be connected to the pixels PX and the data driver DDV. The emission lines EL1 to ELm may extend in the first direction DR1 and be connected to the pixels PX and the emission driver EDV.

The first power line PLL1 may extend in the second direction DR2 and be disposed on the non-display part NDA. The first power line PLL1 may be disposed between the display part DA and the emission driver EDV, however, it is not limited thereto. The first power line PLL1 may also be disposed between the display part DA and the scan driver SDV.

The connection lines CNL may extend in the first direction DR1 and be arranged in the second direction DR2. The connection lines CNL may be connected to the first power line PLL1 and the pixels PX. A first voltage may be applied to the pixels PX through the first power line PLL1 and the connection lines CNL, which are connected to each other.

The second power line PLL2 may be disposed on the non-display part NDA. The second power line PLL2 may extend along the long sides and the other short side of the display panel DP, in which the data driver DDV is not disposed. The second power line PLL2 may be disposed outside relative to the scan driver SDV and the emission driver EDV.

Although not shown, the second power line PLL2 may extend toward the display part DA and be connected to the pixels PX. A second voltage, having a lower level than the first voltage, may be applied to the pixels PX through the second power line PLL2.

The first control line CSL1 may be connected to the scan driver SDV and extend toward the lower end of the display panel DP in a plan view. The second control line CSL2 may be connected to the emission driver EDV and extend toward the lower end of the display panel DP in a plan view. The data driver DDV may be disposed between the first control line CSL1 and the second control line CSL2.

The pads PD may be disposed on the display panel DP. The pads PD may be more adjacent to the lower end of the display panel DP than the data driver DDV. The data driver DDV, the first power line PLL1, the second power line PLL2, the first control line CSL1, and the second control line CSL2 may be connected to the pads PD. The data lines DL1 to DLn may be connected to the data driver DDV, and the data driver DDV may be connected to the pads PD corresponding to the data lines DL1 to DLn.

The light-emitting elements of the display panel DP may be provided by the cell areas CEA shown in FIG. 2.

On the above-described substrate SUB, unit areas corresponding to the display panel DP may be defined. After the light-emitting elements are disposed in the unit areas, the unit areas may be cut. Thus, the display panel DP shown in FIG. 9 may be manufactured.

Although not shown, a timing controller for controlling operations of the scan driver SDV, the data driver DDV, and the emission driver EDV, as well as a voltage generator for generating the first and second voltages, may be disposed on a printed circuit board. The timing controller and the voltage generator may be connected to the corresponding pads PD through the printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The emission driver EDV may generate a plurality of emission signals, and the emission signals may be applied to the pixels PX through the emission lines EL1 to ELm.

The pixels PX may receive the data voltages in response to the scan signals. The pixels PX may emit light with a luminance corresponding to the data voltages in response to the emission signals to display images. The emission time of the pixels PX may be controlled by the emission signals.

The above-described wiring may include the data lines DL1 to DLn. The pads connected to the above-described wiring may include the pads PD shown in FIG. 9. A display panel DP, in which the emission layers of the pixels PX are not provided, may be defined as the above-described substrate SUB.

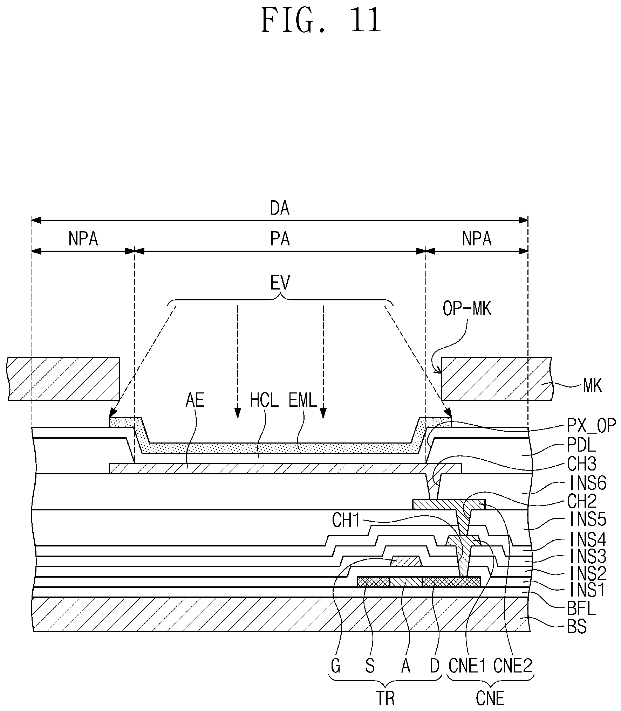

The cross-sectional structure of the substrate SUB, in which the emission layers are not provided, will be described below with reference to FIG. 11. The pads PD are disposed on the substrate SUB, and the substrate SUB may be defined in a state where the printed circuit board is not connected. The pads PD may be connected to a ground terminal (not shown), thereby grounding the pads PD and the data lines DL1 to DLn.

FIG. 10 is a cross-sectional view of illustrating an example of one pixel of the display panel shown in FIG. 9.

Referring to FIG. 10, the pixel PX may be disposed on a base substrate BS and may include a transistor TR and a light-emitting element OLED. The transistors TR and the light-emitting elements OLED of the pixels PX may be connected to the above-described data lines DL1 to DLn and the first and second power lines PLL1 and PLL2.

The transistors TR and the light-emitting elements OLED of the pixels PX may be connected to the pads PD of FIG. 9 through the data lines DL1 to DLn (see FIG. 9) and the first and second power lines PLL1 and PLL2 (see FIG. 9).

The light-emitting element OLED may include a first electrode AE, a second electrode CE, a hole control layer HCL, an electron control layer ECL, and an emission layer EML. The first electrode AE may be an anode electrode, and the second electrode CE may be a cathode electrode.

The transistor TR and light-emitting element OLED may be disposed on the base substrate BS. Although a single transistor TR is illustrated as an example, substantially, the pixel PX may include a plurality of transistors and at least one capacitor to drive the light-emitting element OLED.

The display area DA may include an emission part PA corresponding to the pixel PX and a non-emission part NPA surrounding the light-emitting area PA. The light-emitting element OLED may be disposed on the emission part PA.

The base substrate BS may include a flexible plastic substrate. For example, the base substrate BS may include transparent polyimide (PI). A buffer layer BFL is disposed on the base substrate BS, and the buffer layer BFL may be an inorganic layer.

A semiconductor pattern may be disposed on the buffer layer BFL. The semiconductor pattern may include polysilicon. However, the invention is not limited thereto; the semiconductor pattern may also include amorphous silicon or metal oxide.

The semiconductor pattern may be doped with N-type or P-type dopants. The semiconductor pattern may include heavily doped regions and lightly doped regions. The heavily doped region may have conductivity greater than conductivity of the lightly doped region, and substantially, it may serve as the source and drain electrodes of the transistor TR. The lightly doped region may substantially correspond to the active (or channel) region of the transistor.

The source S, active A, and drain D of the transistor TR may be provided from the semiconductor pattern. A first insulating layer INS1 may be disposed on the semiconductor pattern. A gate G of the transistor TR may be disposed on the first insulating layer INS1. A second insulating layer INS2 may be disposed on the gate G. A third insulating layer INS3 may be disposed on the second insulating layer INS2.

A connection electrode CNE may be disposed between the transistor TR and the light-emitting element OLED to connect the transistor TR to the light-emitting element OLED. The connection electrode CNE may include a first connection electrode CNE1 and a second connection electrode CNE2.

The first connection electrode CNE1 may be disposed on the third insulating layer INS3 and be connected to the drain D through a first contact hole CH1 defined in the first to the third insulating layers INS1 to INS3. A fourth insulating layer INS4 may be disposed on the first connection electrode CNE1. A fifth insulating layer INS5 may be disposed on the fourth insulating layer INS4.

The second connection electrode CNE2 may be disposed on the fifth insulating layer INS5. The second connection electrodes CNE2 may be connected to the first connection electrodes CNE1 through a second contact hole CH2 defined in the fourth insulating layer INS4 and the fifth insulating layer INS5. A sixth insulating layer INS6 may be disposed on the second connection electrodes CNE2. The first insulating layer INS1 to the sixth insulating layer INS6 may be an inorganic layer or an organic layer.

The first electrodes AE may be disposed on the sixth insulating layer INS6. The first electrodes AE may be connected to the second connection electrodes CNE2 through a third contact hole CH3 defined in the sixth insulating INS6. A pixel defining layer PDL through which a predetermined portion of the first electrode AE is exposed may be disposed on the first electrode AE and the sixth insulating layer INS6. An opening PX_OP for allowing a predetermined portion of the first electrode AE to expose therethrough may be defined in the pixel defining layer PDL.

The hole control layer HCL may be disposed on the first electrode AE and the pixel defining layer PDL. The hole control layer HCL may be commonly disposed on both the emission part PA and the non-emission part NPA. The hole control layer HCL may include a hole transport layer and a hole injection layer.

The emission layer EML may be disposed on the hole control layer HCL. The emission layer EML may be disposed in an area corresponding to the opening PX_OP. The emission layer EML may include organic and/or inorganic materials. The emission layer EML may generate light of one of red, green, and blue.

The electron control layer ECL may be disposed on the emission layer EML and the hole control layer HCL. The electron control layer ECL may be commonly disposed on the emission part PA and the non-emission part NPA. The electron control layer ECL may include a hole transport layer and a hole injection layer.

The second electrode CE may be disposed on the electron control layer ECL and commonly disposed on the pixels PX. The layers from the buffer layer BFL to the light-emitting element OLED may be defined as a pixel layer PXL.

A thin film encapsulation layer TFE may be disposed on the light-emitting element OLED. The thin film encapsulation layer TFE may be disposed on the second electrode CE to cover the pixels PX. The thin film encapsulation layer TFE may include at least two inorganic layers and an organic layer between the inorganic layers. The inorganic layer may protect the pixels PX from the moisture/oxygen. The organic layer may protect the pixels PX from foreign substances such as a dust particle.

A first voltage may be applied to the first electrode AE through the transistor TR, and a second voltage, which has a lower level than the first voltage, may be applied to the second electrode CE. Holes and electrons injected into the emission layer EML combine to each other to generate excitons, and as the excitons transition to the ground state, the light-emitting element OLED may emit light.

FIG. 11 is a view for explaining a deposition process shown in FIG. 7E.

Referring to FIGS. 9, 10 and 11, the layers from the base substrate BS to the hole control layer HCL may be defined as the substrate SUB. As described above, the transistors TR may be connected the pads PD through the data lines DL1 to DLn. That is, the substrate SUB may include the data lines DL1 to DLn defined by the above-described lines and the pads PD connected to the data lines DL1 to DLn.

The mask MK may be disposed to face the substrate SUB. The mask MK may be disposed adjacent to the substrate SUB. The deposition material EV may be provided on the substrate SUB through the mask opening OP-MK defined in a top surface of the mask MK. The emission layer EML may be formed on the substrate SUB by the deposition material EV.

According to the embodiment of the invention, the groove for the substrate may be defined in the bottom surface of the electrostatic chuck overlapping the edge of the substrate. Therefore, even if the edge of the substrate lifts, the substrate may still be positioned within the recess, preventing damage to the edge of the substrate.

Although the embodiments of the invention have been described, it is understood that the invention should not be limited to these embodiments but various changes and modifications can be made by one ordinary skilled in the art within the scope of the invention as hereinafter claimed.

## Claims

1. A deposition apparatus (ED) comprising:
a support (SP), which is configured to be disposed on a bottom surface of a substrate (SUB) to overlap an edge of the substrate (SUB) in a plan view;
a clamp (CP) disposed on the support (SP) and configured to be disposed on the edge of the substrate (SUB); and
an electrostatic chuck (ESC) comprising a flat part (MPL) and a plurality of protrusions (PTR), wherein the flat part (MPL) is configured to be disposed on a top surface of the substrate (SUB) and the plurality of protrusions (PTR) protrude from an edge of the flat part (MPL),
wherein a part of the clamp (CP) is disposed between protrusions (PTR) adjacent to each other among the plurality of protrusions (PTR), and
a groove (GR, GRa) is defined in a bottom surface (PTR-L) of each of the plurality of protrusions (PTR) and configured to overlap the edge of the substrate (SUB) in the plan view.

2. The deposition apparatus (ED) of claim 1, wherein the plurality of protrusions (PTR) extend from the flat part (MPL) in a first direction (DR1), and the groove (GR, GRa) has a width (W1, W2) of about 3 millimeters (mm) to about 7 mm in the first direction (DR1).

3. The deposition apparatus (ED) of claim 2, wherein, in the plan view, the groove (GR) extends from one side to an opposite side of each of the plurality of protrusions (PTR) in a second direction (DR2) intersecting the first direction (DR1), optionally wherein the groove (GR) has a depth (D1) of about 0.5 mm to about 5 mm.

4. The deposition apparatus (ED) of claim 2, wherein, in the plan view, the groove (GRa) is defined in plurality in the bottom surface (PTR-L) of each of the plurality of protrusions (PTR) and the plurality of grooves (GRa) are adjacent to opposite sides of each of the plurality of protrusions (PTR) in a second direction (DR2) intersecting the first direction (DR1).

5. The deposition apparatus (ED) of claim 4, wherein each of the grooves (GRa) has a length (L1) of about 3 mm to about 30 mm in the second direction (DR2), optionally wherein each of the grooves (GRa) has a depth (D1) of about 0.5 mm to about 5 mm.

6. The deposition apparatus (ED) of any one of claims 1 to 5, further comprising:
a mask frame (MF) disposed below the support (SP) to define a frame opening (OP-MF) therein; and
a mask (MK) disposed on a top surface of the mask frame (MF).

7. The deposition apparatus (ED) of any one of claims 1 to 6, wherein:
(i) the plurality of protrusions (PTR) comprise:
a first protrusion (PTR1) extending from the flat part (MPL) in a first direction (DR1); and
a second protrusion (PTR2) extending from the flat part (MPL) in a second direction (DR2) intersecting the first direction (DR1),
wherein the groove (GR, GRa) is provided in plurality,
a groove (GR, GRa) defined in a bottom surface (PTR-L) of the first protrusion (PTR1) extends in the second direction (DR2), and
a groove (GR, GRa) defined in a bottom surface (PTR-L) of the second protrusion (PTR2) extends in the first direction (DR1); and/or
(ii) each of the protrusions (PTR) has a variable thickness.

8. A deposition apparatus (ED) comprising:
a support (SP), which is configured to be disposed on a bottom surface of a substrate (SUB) to overlap an edge of the substrate (SUB) in a plan view;
a clamp (CP) disposed on the support (SP) and configured to overlap the edge of the substrate (SUB); and
an electrostatic chuck (ESC) comprising a flat part (MPL) and a plurality of protrusions (PTR), wherein the flat part (MPL) is configured to be disposed on a top surface of the substrate (SUB) and the plurality of protrusions (PTR) extend from the flat part (MPL),
wherein a part of the clamp (CP) is disposed between protrusions (PTR) adjacent to each other among the plurality of protrusions (PTR), and
a bottom surface (PTR-L) of each of the plurality of protrusions (PTR) has a stepped portion.

9. The deposition apparatus (ED) of claim 8, wherein the bottom surface (PTR-L) of each of the plurality of protrusions (PTR) comprises:
a first surface (PL1), which is configured to overlap the edge of the substrate (SUB); and
a second surface (PL2), which is configured to be disposed on the top surface of the substrate (SUB),
wherein the first surface (PL1) has a height greater than a height of the second surface (PL2).

10. The deposition apparatus (ED) of claim 9, wherein a groove (GR, GRa) is defined in a bottom surface (PTR-L) of each of the plurality of protrusions (PTR), which is configured to overlap the edge of the substrate (SUB), and
the groove (GR, GRa) is defined by the first surface (PL1).

11. The deposition apparatus (ED) of claim 10, wherein:
(i) the plurality of protrusions (PTR) extend from the flat part (MPL) in the first direction (DR1), and
in the plan view, the groove (GR) extends from the one side to an opposite side of each of the plurality of protrusions (PTR) in a second direction (DR2) intersecting the first direction (DR1); or
(ii) the plurality of protrusions (PTR) extend from the flat part (MPL) in the first direction (DR1),
the groove (GRa) is defined in plurality in the bottom surface (PTR-L) of each of the plurality of protrusions (PTR), and
in the plan view, the plurality of grooves (GRa) are defined adjacent to opposite sides of each of the plurality of protrusions (PTR) in a second direction (DR2) intersecting the first direction (DR1) and
wherein each of the grooves (GRa) has a length of about 3 mm to about 30 mm in the second direction (DR2).

12. The deposition apparatus (ED) of claim 10 or claim 11, wherein the groove (GR, GRa) has a depth (D1) of about 0.5 mm to about 5 mm.

13. A deposition method comprising:
placing a substrate (SUB) between a support (SP) and a clamp (CP) to fix the substrate (SUB);
moving an electrostatic chuck (ESC), which is disposed on the support (SP) and the clamp (CP), downward to be disposed adjacent to a top surface of the substrate (SUB);
moving the electrostatic chuck (ESC) downward to be disposed directly on the top surface of the substrate (SUB); and
moving the support (SP), the clamp (CP), and the electrostatic chuck (ESC) downward so that the substrate (SUB) is disposed directly on a top surface of a mask (MK) disposed below the support (SP),
wherein the electrostatic chuck (ESC) comprises:
a flat part (MPL) having a major surface parallel to a plane defined by a first direction (DR1) and a second direction (DR2) intersecting the first direction (DR1); and
a plurality of protrusions (PTR) extending from an edge of the flat part (MPL) in the first direction (DR1) and overlapping an edge of the substrate (SUB) in a direction (DR3) perpendicular to the plane,
wherein a groove (GR, GRa) is defined in a bottom surface (PTR-L) of each of the plurality of protrusions (PTR), which overlaps the edge of the substrate (SUB) in the direction (DR3) perpendicular to the plane.

14. The method of claim 13, wherein, when the electrostatic chuck (ESC) is disposed adjacent to the top surface of the substrate (SUB), the edge of the substrate (SUB) is disposed within the groove (GR, GRa).

15. The method of claim 13 or claim 14, wherein:
(i) in a plan view, the groove (GR) extends from one side to an opposite side of each of the plurality of protrusions (PTR) in the second direction (DR2); or
(ii) a part of the clamp (CP) is disposed between protrusions (PTR) adjacent to each other in the second direction (DR2),
in a plan view, the groove (GRa) is defined in plurality in the bottom surface (PTR-L) of each of the plurality of protrusions (PTR), and
the plurality of grooves (GRa) are defined adjacent to opposite sides of each of the plurality of protrusions (PTR), which face the clamp (CP).
